# EUROPÄISCHE PATENTSCHRIFT

(11) **EP 2 931 673 B1**
(45) Veröffentlichungstag und Bekanntmachung des Hinweises auf die Patenterteilung: **27.05.2020**
(21) Anmeldenummer: 13799580.9
(22) Anmeldetag: 05.12.2013
(51) Int. Cl.: C03C 17/36, B32B 17/10, H05B 3/86

(54) **TRANSPARENTE SCHEIBE MIT ELEKTRISCH LEITFÄHIGER BESCHICHTUNG**
TRANSPARENT PANE WITH ELECTRICALLY CONDUCTIVE COATING
VITRE TRANSPARENTE DOTÉE D'UN REVÊTEMENT ÉLECTRIQUE À POUVOIR CONDUCTEUR

(30) Priorität: 17.12.2012 EP 12197445
(43) Veröffentlichungstag der Anmeldung: 21.10.2015
(73) Patentinhaber: Saint-Gobain Glass France, 92400 Courbevoie (FR)
(72) Erfinder: FISCHER, Klaus, 52477 Alsdorf (DE); JANZYK, Sebastian, 52134 Herzogenrath (DE); WEISSLER, Ariane, 52064 Aachen (DE)
(74) Vertreter: Gebauer, Dieter Edmund
(86) Internationale Anmeldenummer: PCT/EP2013/075641
(87) Internationale Veröffentlichungsnummer: WO 2014/095388

(56) Entgegenhaltungen:
- EP-A1- 1 849 594
- EP-A1- 2 444 381
- EP-A2- 0 803 481
- WO-A1-00/37383
- DE-C1- 19 848 751
- FR-A1- 2 936 510
- US-B1- 6 398 925
- US-B1- 6 540 884

## Beschreibung

Die Erfindung betrifft eine transparente Scheibe mit elektrisch leitfähiger Beschichtung, ein Verfahren zu deren Herstellung und deren Verwendung.

Das Sichtfeld einer Fahrzeugscheibe, insbesondere einer Windschutzscheibe muss frei von Eis und Beschlag gehalten werden. Bei Kraftfahrzeugen mit Verbrennungsmotor kann beispielsweise ein mittels Motorwärme erwärmter Luftstrom auf die Scheiben gelenkt werden.

Alternativ kann die Scheibe eine elektrische Heizfunktion aufweisen. Aus DE 103 52 464 A1 ist beispielsweise eine Verbundglasscheibe bekannt, bei der zwischen zwei Glasscheiben elektrisch beheizbare Drähte eingelegt sind. Die spezifische Heizleistung P, beispielsweise etwa 600 W/m², kann dabei durch den ohmschen Widerstand der Drähte eingestellt werden. Aufgrund von Design- und Sicherheitsaspekten muss die Anzahl sowie der Durchmesser der Drähte möglichst klein gehalten werden. Die Drähte dürfen bei Tageslicht und nachts bei Scheinwerferlicht visuell nicht oder kaum wahrnehmbar sein.

Es sind auch transparente, elektrisch leitfähige Beschichtungen insbesondere auf Silberbasis bekannt. WO 03/024155 A2 offenbart beispielsweise eine elektrisch leitfähige Beschichtung mit zwei Silberlagen. Solche Beschichtungen weisen in der Regel Flächenwiderstände im Bereich von 3 Ohm/Quadrat bis 5 Ohm/Quadrat auf.

Die spezifische Heizleistung P einer elektrisch beheizbaren Beschichtung mit einem Flächenwiderstand R_{Quadrat}, einer Betriebsspannung U und einem Abstand h zwischen zwei Sammelleitern lässt sich mit der Formel P = U²/(R_{Quadrat}*h²) berechnen. Der Abstand h zwischen zwei Sammelleitern beträgt bei typischen Windschutzscheiben von Personenkraftwagen etwa 0,8 m, was ungefähr der Scheibenhöhe entspricht. Um bei einem Flächenwiderstand von 4 Ohm/Quadrat eine gewünschte spezifische Heizleistung P von 600 W/m² zu erzielen, ist eine Betriebsspannung U von etwa 40 V notwendig. Da die Bordspannung von Kraftfahrzeugen üblicherweise 14 V beträgt, ist ein Netzteil oder ein Spannungswandler notwendig, um eine Betriebsspannung von 40 V zu erzeugen. Eine Spannungserhöhung von 14 V auf 40 V ist immer mit elektrischen Leitungsverlusten und zusätzlichen Kosten für zusätzliche Bauelemente verbunden.

US 2007/0082219 A1 und US 2007/0020465 A1 offenbaren transparente, elektrisch leitfähige Beschichtungen mit mindestens drei Silberlagen. Für Beschichtungen auf Basis dreier Silberlagen sind in US 2007/0082219 A1 Flächenwiderstände um 1 Ohm/Quadrat angegeben. Für eine Betriebsspannung U = 14 V, einen Flächenwiderstand R_{Quadrat} = 1 Ohm/Quadrat und einen Abstand h = 0,8 m ergibt sich eine spezifische Heizleistung P von etwa 300 W/m².

Zur Bereitstellung einer ausreichenden spezifischen Heizleistung P, beispielsweise etwa 500 W/m², insbesondere zur Beheizung größerer Scheiben ist eine weitere Reduzierung des Flächenwiderstands der elektrisch beheizbaren Beschichtung erforderlich. Dies kann bei einer elektrisch beheizbaren Beschichtung mit typischerweise drei Silberlagen durch eine Erhöhung der Dicke der einzelnen Silberschichten erreicht werden. Eine zu große Schichtdicke der Silberschichten führt jedoch zu mangelhaften optischen Eigenschaften der Scheibe, insbesondere im Hinblick auf Transmission und Farbwirkung, so dass gesetzliche Vorschriften, wie sie beispielsweise in ECE R 43 ("Einheitliche Vorschriften für die Genehmigung des Sicherheitsglases und der Verbundglaswerkstoffe") festgelegt sind, nicht eingehalten werden können. Die Silberschichten sind demnach so zu bemessen, dass die Leitfähigkeit hoch genug für eine ausreichende Beheizung bei gleichzeitig genügender Transmission ist. Die Leitfähigkeit der Schichten hängt dabei vor allem von der Kristallinität des abgeschiedenen Silbers ab.

Im Allgemeinen erfolgt die Abscheidung des Schichtsystems auf eine Glasscheibe vor dem Biegen und der Lamination der Windschutzscheibe. Somit muss die Beschichtung eine ausreichende thermische Belastbarkeit aufweisen. Die Erwärmung der beschichteten Scheibe im Biegeprozess führt jedoch zu einer Oxidation der Silberschicht. EP 2444381 A1 löst diese Problemstellung durch Aufbringen einer Blockerschicht benachbart zur silberhaltigen Schicht. Diese Blockerschicht dient insbesondere zur Stabilisierung der silberhaltigen Schicht während der Wärmebehandlung und verbessert die optische Qualität der elektrisch beheizbaren Beschichtung. EP 2444381 A1 offenbart eine Blockerschicht enthaltend Niob, Titan, Nickel, Chrom oder Legierungen davon, besonders bevorzugt NickelChrom-Legierungen. Ein Nachteil dieser Lösung ist jedoch, dass die Blockerschicht einen unerwünschten negativen Einfluss auf die Kristallinität der silberhaltigen Schicht hat.

Die Aufgabe der vorliegenden Erfindung besteht darin, eine transparente Scheibe mit elektrisch leitfähiger Beschichtung, die eine im Vergleich zum Stand der Technik verbesserte Kristallinität und einen geringeren Flächenwiderstand R_{Quadrat} aufweist, sowie ein wirtschaftliches Verfahren zu deren Herstellung bereitzustellen. Die Scheibe soll dabei eine hohe Transmission und eine hohe Farbneutralität aufweisen und kostengünstig herstellbar sein.

Die Aufgabe der vorliegenden Erfindung wird erfindungsgemäß durch eine transparente Scheibe mit leitfähiger Beschichtung, ein Verfahren zu deren Herstellung und deren Verwendung gemäß den unabhängigen Ansprüchen gelöst. Bevorzugte Ausführungsformen gehen aus den Unteransprüchen hervor.

Die erfindungsgemäße transparente Scheibe umfasst mindestens ein transparentes Substrat und mindestens eine elektrisch leitfähige Beschichtung auf mindestens einer Oberfläche des transparenten Substrats, wobei
- die elektrisch leitfähige Beschichtung mindestens zwei übereinander angeordnete funktionelle Schichten aufweist und jede funktionelle Schicht mindestens
- eine Schicht optisch hochbrechenden Materials mit einem Brechungsindex größer oder gleich 2,1,
- oberhalb der Schicht optisch hochbrechenden Materials eine Glättungsschicht, die zumindest ein nichtkristallines Oxid enthält,
- oberhalb der Glättungsschicht eine untere Anpassungsschicht,
- oberhalb der unteren Anpassungsschicht eine elektrisch leitfähige Schicht und
- oberhalb der elektrisch leitfähigen Schicht eine obere Anpassungsschicht umfasst,
- die untere Anpassungsschicht und optional die obere Anpassungsschicht ein im gesamten Schichtquerschnitt homogen verteiltes Gettermaterial aus der Gruppe bestehend aus Niob, Titan, Barium, Magnesium, Tantal, Zirconium, Thorium, Palladium, Platin und Legierungen davon enthält und
die das Gettermaterial enthaltende untere Anpassungsschicht in direktem Kontakt zur elektrisch leitfähigen Schicht steht.

Das Gettermaterial der Anpassungsschichten schützt dabei die benachbarten elektrisch leitfähigen Schichten vor Oxidation. Durch den erfindungsgemäßen Schichtaufbau sind somit alle elektrisch leitfähigen Schichten der transparenten Scheibe gegen Oxidation geschützt. Da die erfindungsgemäßen Anpassungsschichten den elektrisch leitfähigen Schichten direkt benachbart sind wird die Kristallinität der Anpassungsschichten optimal auf die leitfähigen Schichten übertragen.

Ist eine erste Schicht oberhalb einer zweiten Schicht angeordnet, so bedeutet dies im Sinne der Erfindung, dass die erste Schicht weiter vom transparenten Substrat entfernt angeordnet ist, so bedeutet dies im Sinne der Erfindung, dass die zweite Schicht weiter vom transparenten Substrat entfernt angeordnet ist als die erste Schicht. Die oberste funktionelle Schicht ist diejenige funktionelle Schicht, die den größten Abstand zum transparenten Substrat aufweist. Die unterste funktionelle Schicht ist diejenige funktionelle Schicht, die den geringsten Abstand zum transparenten Substrat aufweist.

Eine Schicht im Sinne der Erfindung kann aus einem Material bestehen. Eine Schicht kann aber auch zwei oder mehrere Einzelschichten unterschiedlichen Materials umfassen. Eine erfindungsgemäße funktionelle Schicht umfasst beispielsweise zumindest eine Schicht optisch hochbrechenden Materials, eine Glättungsschicht, eine untere und eine obere Anpassungsschicht und eine elektrisch leitfähige Schicht.

Ist eine erste Schicht oberhalb oder unterhalb einer zweiten Schicht angeordnet, so bedeutet dies im Sinne der Erfindung nicht notwendigerweise, dass sich die erste und die zweite Schicht in direktem Kontakt miteinander befinden. Es können eine oder mehrere weitere Schichten zwischen der ersten und der zweiten Schicht angeordnet sein, sofern dies nicht explizit ausgeschlossen wird.

Die elektrisch leitfähige Beschichtung ist erfindungsgemäß zumindest auf einer Oberfläche des transparenten Substrats aufgebracht. Es können auch beide Oberflächen des transparenten Substrats mit einer erfindungsgemäßen elektrisch leitfähigen Beschichtung versehen sein.

Die elektrisch leitfähige Beschichtung kann sich über die gesamte Oberfläche des transparenten Substrats erstrecken. Die elektrisch leitfähige Beschichtung kann sich alternativ aber auch nur über einen Teil der Oberfläche des transparenten Substrats erstrecken. Die elektrisch leitfähige Beschichtung erstreckt sich bevorzugt über mindestens 50%, besonders bevorzugt über mindestens 70% und ganz besonders bevorzugt über mindestens 90% der Oberfläche des transparenten Substrats.

Die elektrisch leitfähige Beschichtung kann direkt auf der Oberfläche des transparenten Substrats aufgebracht sein. Die elektrisch leitfähige Beschichtung kann alternativ auf einer Trägerfolie aufgebracht sein, die mit dem transparenten Substrat verklebt ist.

Mit optisch hochbrechendem Material wird im Sinne der Erfindung ein Material bezeichnet, dessen Brechungsindex größer oder gleich 2,1 beträgt. Nach dem Stand der Technik sind Schichtfolgen bekannt, bei denen die elektrisch leitfähigen Schichten zwischen jeweils zwei dielektrischen Schichten angeordnet sind. Diese dielektrischen Schichten enthalten üblicherweise Siliziumnitrid. Die erfindungsgemäßen Schichten optisch hochbrechenden Materials führen zu einer Verringerung des Flächenwiderstands der elektrisch leitfähigen Schichten bei gleichzeitig guten optischen Eigenschaften der transparenten Scheibe, insbesondere hoher Transmission und neutraler Farbwirkung. Zusammen mit den erfindungsgemäßen Glättungsschichten lassen sich durch die Schichten optisch hochbrechenden Materials vorteilhaft geringe Werte für den Flächenwiderstand und damit hohe spezifische Heizleistungen erreichen.

Die angegebenen Werte für Brechungsindizes sind bei einer Wellenlänge von 550 nm gemessen.

Die erfindungsgemäße transparente Scheibe mit elektrisch leitfähiger Beschichtung weist bevorzugt eine Gesamttransmission von größer 70 % auf. Der Begriff Gesamttransmission bezieht sich auf das durch ECE-R 43, Anhang 3, § 9.1 festgelegte Verfahren zur Prüfung der Lichtdurchlässigkeit von Kraftfahrzeugscheiben.

Die elektrisch leitfähige Beschichtung weist bevorzugt einen Flächenwiderstand von kleiner 1 Ohm/Quadrat auf. Der Flächenwiderstand der elektrisch leitfähigen Beschichtung beträgt besonders bevorzugt von 0,4 Ohm/Quadrat bis 0,9 Ohm/Quadrat. In diesem Bereich für den Flächenwiderstand werden vorteilhaft hohe spezifische Heizleistungen P erreicht.

Die untere Anpassungsschicht und optional die obere Anpassungsschicht umfasst ein im gesamten Schichtquerschnitt homogen verteiltes Gettermaterial. Das Gettermaterial entstammt der Gruppe bestehend aus Niob, Titan, Barium, Magnesium, Tantal, Zirconium, Thorium, Palladium, Platin. Das Gettermaterial bindet Sauerstoff, so dass benachbarte leitfähige Schichten vor einer Oxidation geschützt sind. Die Aufbringung einer zusätzlichen Blockerschicht enthaltend ein solches Gettermaterial ist dabei nicht notwendig. Die nach dem Stand der Technik bekannten Blockerschichten behindern die Fortsetzung der Kristallinität der darunter liegenden Anpassungsschicht auf die leitfähige Schicht. Ein Wegfall der Blockerschicht verbessert somit die Kristallinität der leitfähigen Schicht und dadurch bedingt auch deren Leitfähigkeit. Dadurch kann die spezifische Heizleistung durch die besonders vorteilhafte erfindungsgemäße Kombination der Anpassungsschicht und des Gettermaterials erhöht werden.

Das Gettermaterial der erfindungsgemäßen Anpassungsschicht ist homogen in dieser verteilt und im Gegensatz zu den nach dem Stand der Technik bekannten Blockerschichten nicht nur an der Oberfläche der Anpassungsschicht angebracht, sondern in dieser enthalten. Im Querschnitt der Anpassungsschicht kann das Gettermaterial auch lokale Akkumulationen zeigen, gemittelt ergibt sich jedoch eine homogene Verteilung des Gettermaterials über die gesamte Querschnittsfläche. An der der Glättungsschicht zugewandten Fläche der Anpassungsschicht ist somit genau so viel Gettermaterial verfügbar wie an der der leitfähigen Schicht zugewandten Oberfläche. Durch diese gleichmäßige Verteilung des Gettermaterials in der Anpassungsschicht ist genügend Gettermaterial zur Aufnahme von Sauerstoff vorhanden. Zusätzlich wird die Kristallinität der Anpassungsschicht optimal auf die leitfähige Schicht übertragen, da die Oberfläche der Anpassungsschicht nicht von einer Blockerschicht verdeckt ist. Die erfindungsgemäße elektrisch leitfähige Beschichtung besitzt somit im Vergleich zum Stand der Technik eine bei gleicher Oxidationsstabilität erhöhte Leitfähigkeit.

Das Gettermaterial kann des Weiteren Nickel, Chrom, Aluminium und/oder Legierungen davon enthalten.

Zur Erhöhung der Gesamttransmission und/oder zur Verringerung des Flächenwiderstands kann die transparente Scheibe mit elektrisch leitfähiger Beschichtung einer Temperaturbehandlung, beispielsweise bei einer Temperatur von 500 °C bis 700 °C, unterzogen werden.

Es hat sich gezeigt, dass die erfindungsgemäße elektrisch leitfähige Beschichtung einer solchen Temperaturbehandlung unterzogen werden kann, ohne dass die Beschichtung durch Oxidation beschädigt wird. Die erfindungsgemäße transparente Scheibe kann zudem konvex oder konkav gebogen werden, ohne dass die Beschichtung durch Oxidation beschädigt wird. Das sind große Vorteile der erfindungsgemäßen elektrisch leitfähigen Beschichtung.

Erfindungsgemäß enthält die untere Anpassungsschicht und/oder die obere Anpassungsschicht das Gettermaterial in einer Konzentration von 3 Gew.-% bis 10 Gew.-%, ganz besonders bevorzugt 3 Gew.-% bis 7 Gew.-%, insbesondere 4 Gew.-% bis 6 Gew.-%. Im Konzentrationsbereich oberhalb von 3 Gew.-% ist dabei ein besonders guter Schutz der elektrisch leitfähigen Schichten vor Oxidation zu beobachten.

Bevorzugt enthält das Gettermaterial Titan.

Die elektrisch leitfähige Beschichtung weist zwei bis fünf funktionelle Schichten auf.

In einer bevorzugten Ausführung der Erfindung weist die elektrisch leitfähige Beschichtung drei funktionelle Schichten auf. Die Herstellung einer elektrisch leitfähigen Beschichtung mit vier oder mehr elektrisch leitfähigen Schichten ist technisch aufwendig und kostenintensiv. Aufgrund der verbesserten Leitfähigkeit des erfindungsgemäßen funktionellen Schichtaufbaus wird jedoch auch mit drei funktionellen Schichten eine ausreichend hohe Heizleistung erzielt.

In einer weiteren bevorzugten Ausführungsform weist die elektrisch leitfähige Beschichtung vier funktionelle Schichten auf. Da im erfindungsgemäßen Verfahren die Anpassungsschicht und das Gettermaterial aus einem gemeinsamen Target, das beide Komponenten enthält, abgeschieden werden, ergibt sich in der Beschichtungsanlage ein freier Kathodenplatz. Dieser Kathodenplatz beherbergt in einer Anlage nach dem Stand der Technik das Target zur Abscheidung der Blockerschicht. Bei Freiwerden dieses Kathodenplatzes kann dort ein weiteres Target zur Abscheidung einer vierten elektrisch leitfähigen Schicht angebracht werden. Dadurch wird die Herstellung einer elektrisch leitfähigen Beschichtung mit vier funktionellen Schichten bei gleicher Anlagengröße wesentlich vereinfacht und wesentlich wirtschaftlicher.

Die Schicht optisch hochbrechenden Materials weist bevorzugt einen Brechungsindex n von 2,1 bis 2,5 auf, besonders bevorzugt von 2,1 bis 2,3.

Die Schicht optisch hochbrechenden Materials enthält bevorzugt zumindest ein Silizium-Metall-Mischnitrid, besonders bevorzugt Silizium-Zirkonium-Mischnitrid. Das ist besonders vorteilhaft im Hinblick auf den Flächenwiderstand der elektrisch leitfähigen Beschichtung. Das Silizium-Zirkonium-Mischnitrid weist bevorzugt Dotierungen auf. Die Schicht optisch hochbrechenden Materials kann beispielsweise ein aluminium-dotiertes Silizium-Zirkonium-Mischnitrid (SiZrNₓ:Al) enthalten.

Das Silizium-Zirkonium-Mischnitrid wird bevorzugt mittels magnetfeldunterstützter Kathodenzerstäubung mit einem Target abgeschieden, welches von 40 Gew.-% bis 70 Gew.-% Silizium, von 30Gew.-% bis 60 Gew.-% Zirkonium und von 0 Gew.-% bis 10 Gew.-% Aluminium sowie herstellungsbedingte Beimengungen enthält. Das Target enthält besonders bevorzugt von 45 Gew.-% bis 60 Gew.-% Silizium, von 35 Gew.-% bis 55 Gew.-% Zirkonium und von 3 Gew.-% bis 8 Gew.-% Aluminium sowie herstellungsbedingte Beimengungen. Die Abscheidung des Silizium-Zirkonium-Mischnitrids erfolgt bevorzugt unter Zugabe von Stickstoff als Reaktionsgas während der Kathodenzerstäubung.

Die Schicht optisch hochbrechenden Materials kann aber auch beispielsweise zumindest Silizium-Aluminium-Mischnitrid, Silizium-Hafnium-Mischnitrid oder Silizium-Titan-Mischnitrid enthalten. Die Schicht optisch hochbrechenden Materials kann alternativ beispielsweise MnO, WO₃, Nb₂O₅, Bi₂O₃, TiO₂, Zr₃N₄ und/oder AIN enthalten.

Die Schichtdicke jeder Schicht optisch hochbrechenden Materials, die zwischen zwei elektrisch leitfähigen Schichten angeordnet ist, beträgt bevorzugt von 35 nm bis 70 nm, besonders bevorzugt von 45 nm bis 60 nm. In diesem Bereich für die Schichtdicke werden besonders vorteilhafte Flächenwiderstände der elektrisch leitfähigen Beschichtung und besonders gute optische Eigenschaften der transparenten Scheibe erreicht. Eine Schicht optisch hochbrechenden Materials ist im Sinne der Erfindung zwischen zwei elektrisch leitfähigen Schichten angeordnet, wenn zumindest eine elektrisch leitfähige Schicht oberhalb der Schicht optisch hochbrechenden Materials und wenn zumindest eine elektrisch leitfähige Schicht unterhalb der Schicht optisch hochbrechenden Materials angeordnet ist. Die Schicht optisch hochbrechenden Materials steht aber erfindungsgemäß nicht in direktem Kontakt zu den benachbarten elektrisch leitfähigen Schichten.

Die Schichtdicke der untersten Schicht optisch hochbrechenden Materials beträgt bevorzugt von 20 nm bis 40 nm. Damit werden besonders gute Ergebnisse erzielt.

In einer vorteilhaften Ausgestaltung der Erfindung ist oberhalb der obersten funktionellen Schicht eine Abdeckschicht angeordnet. Die Abdeckschicht schützt die darunter angeordneten Schichten vor Korrosion. Die Abdeckschicht ist bevorzugt dielektrisch. Die Abdeckschicht kann beispielsweise Siliziumnitrid und/oder Zinnoxid enthalten.

Die Abdeckschicht enthält bevorzugt zumindest ein optisch hochbrechendes Material mit einem Brechungsindex größer oder gleich 2,1. Die Abdeckschicht enthält besonders bevorzugt zumindest ein Silizium-Metall-Mischnitrid, insbesondere Silizium-Zirkonium-Mischnitrid, wie Aluminium-dotiertes Silizium-Zirkonium-Mischnitrid. Das ist besonders vorteilhaft im Hinblick auf die optischen Eigenschaften der erfindungsgemäßen transparenten Scheibe. Die Abdeckschicht kann aber auch andere Silizium-Metall-Mischnitride enthalten, beispielsweise Silizium-Aluminium-Mischnitrid, Silizium-Hafnium-Mischnitrid oder Silizium-Titan-Mischnitrid. Die Abdeckschicht kann alternativ auch beispielsweise MnO, WO₃, Nb₂O₅, Bi₂O₃, TiO₂, Zr₃N₄ und/oder AIN enthalten.

Die Schichtdicke der Abdeckschicht beträgt bevorzugt von 20 nm bis 40 nm. Damit werden besonders gute Ergebnisse erzielt.

Jede funktionelle Schicht der elektrisch leitfähigen Beschichtung umfasst erfindungsgemäß zumindest eine Glättungsschicht. Die Glättungsschicht ist unterhalb der ersten Anpassungsschicht angeordnet, bevorzugt zwischen der Schicht optisch hochbrechenden Materials und der ersten Anpassungsschicht. Die Glättungsschicht steht bevorzugt in direktem Kontakt zur ersten Anpassungsschicht. Die Glättungsschicht bewirkt eine Optimierung, insbesondere Glättung der Oberfläche für eine anschließend oberhalb aufgebrachte elektrisch leitfähige Schicht. Eine auf eine glattere Oberfläche abgeschiedene elektrisch leitfähige Schicht weist einen höheren Transmissionsgrad bei einem gleichzeitig niedrigeren Flächenwiderstand auf.

Die Glättungsschicht enthält zumindest ein nichtkristallines Oxid. Das Oxid kann amorph oder teilamorph (und damit teilkristallin) sein, ist aber nicht vollständig kristallin. Die nichtkristalline Glättungsschicht weist eine geringe Rauheit auf und bildet somit eine vorteilhaft glatte Oberfläche für die oberhalb der Glättungsschicht aufzubringenden Schichten. Die nichtkristalline Glättungsschicht bewirkt weiter eine verbesserte Oberflächenstruktur der direkt oberhalb der Glättungsschicht abgeschiedenen Schicht, welche bevorzugt die erste Anpassungsschicht ist. Die Glättungsschicht kann beispielsweise zumindest ein Oxid eines oder mehrerer der Elemente Zinn, Silizium, Titan, Zirkonium, Hafnium, Zink, Gallium und Indium enthalten.

Die Glättungsschicht enthält bevorzugt ein nichtkristallines Mischoxid. Die Glättungsschicht enthält ganz besonders bevorzugt ein Zinn-Zink-Mischoxid. Das Mischoxid kann Dotierungen aufweisen. Die Glättungsschicht kann beispielsweise ein Antimon-dotiertes Zinn-Zink-Mischoxid (SnZnOₓ:Sb) enthalten. Das Mischoxid weist bevorzugt einen unterstöchiometrischen Sauerstoffgehalt auf. Ein Verfahren zur Herstellung von Zinn-Zink-Mischoxid-Schichten durch reaktive Kathodenzerstäubung ist beispielsweise aus DE 198 48 751 C1 bekannt. Das Zinn-Zink-Mischoxid wird bevorzugt mit einem Target abgeschieden, welches von 25 Gew. % bis 80 Gew. % Zink, von 20 Gew. % bis 75 Gew. % Zinn und von 0 Gew. % bis 10 Gew. % Antimon sowie herstellungsbedingte Beimengungen enthält. Das Target enthält besonders bevorzugt von 45 Gew. % bis 75 Gew. % Zink, von 25 Gew. % bis 55 Gew. % Zinn und von 1 Gew. % bis 5 Gew. % Antimon sowie herstellungsbedingte Beimengungen anderer Metalle. Die Abscheidung des Zinn-Zink-Mischoxids erfolgt unter Zugabe von Sauerstoff als Reaktionsgas während der Kathodenzerstäubung.

Die Schichtdicke einer Glättungsschicht beträgt bevorzugt von 3 nm bis 20 nm besonders bevorzugt von 4 nm bis 12 nm. Die Glättungsschicht weist bevorzugt einen Brechungsindex von kleiner als 2,2 auf.

Die elektrisch leitfähige Schicht enthält bevorzugt zumindest ein Metall, beispielsweise Gold oder Kupfer, oder eine Legierung, besonders bevorzugt Silber oder eine silberhaltige Legierung. Die elektrisch leitfähige Schicht kann aber auch andere, dem Fachmann bekannte elektrisch leitfähige Materialen enthalten.

In einer vorteilhaften Ausgestaltung der Erfindung enthält die elektrisch leitfähige Schicht mindestens 90 Gew.-% Silber, bevorzugt mindestens 99,9 Gew.-% Silber. Die elektrisch leitfähige Schicht wird bevorzugt mit gängigen Verfahren zur Schichtabscheidung von Metallen, beispielsweise durch Vakuumverfahren wie die magnetfeldunterstützte Kathodenzerstäubung aufgebracht.

Die elektrisch leitfähige Schicht weist bevorzugt eine Schichtdicke von 8 nm bis 25 nm, besonders bevorzugt von 10 nm bis 20 nm auf. Das ist besonders vorteilhaft im Hinblick auf die Transparenz und den Flächenwiderstand der elektrisch leitfähigen Schicht.

Die Gesamtschichtdicke aller elektrisch leitfähigen Schichten beträgt erfindungsgemäß von 32 nm bis 75 nm. In diesem Bereich für die Gesamtdicke aller elektrisch leitfähigen Schichten wird bei für Fahrzeugscheiben, insbesondere Windschutzscheiben typischen Abständen h zwischen zwei Sammelleitern und einer Betriebsspannung U im Bereich von 12 V bis 15 V vorteilhaft eine ausreichend hohe spezifische Heizleistung P und gleichzeitig eine ausreichend hohe Transmission erreicht. Zu geringere Gesamtschichtdicken aller elektrisch leitfähigen Schichten ergeben einen zu hohen Flächenwiderstand R_{Quadrat} und damit eine zu geringe spezifische Heizleistung P. Zu große Gesamtschichtdicken aller elektrisch leitfähigen Schichten verringern die Transmission durch die Scheibe zu stark, so dass die Erfordernisse an die Transmission von Fahrzeugscheiben nach ECE R 43 nicht erfüllt werden. Es hat sich gezeigt, dass besonders gute Ergebnisse mit einer Gesamtschichtdicke aller elektrisch leitfähigen Schichten von 50 nm bis 60 nm, insbesondere von 51 nm bis 58 nm erzielt werden. Das ist besonders vorteilhaft im Hinblick auf den Flächenwiderstand der elektrisch leitfähigen Beschichtung und die Transmission der transparenten Scheibe.

Die untere Anpassungsschicht und/oder die obere Anpassungsschicht enthält bevorzugt Zinkoxid ZnO_{1-δ} mit 0 < δ < 0,01. Das Zinkoxid wird bevorzugt unterstöchiometrisch bezüglich des Sauerstoffs abgeschieden um eine Reaktion von überschüssigem Sauerstoff mit der silberhaltigen leitfähigen Schicht sowie mit dem Gettermaterial zu vermeiden. Neben Zinkoxid können auch weitere keramische Bestandteile in den Anpassungsschichten enthalten sein. Bevorzugt werden weitere Oxide, beispielsweise Aluminiumoxid, zugefügt. Die Zinkoxid-Schicht wird bevorzugt durch magnetfeldunterstützte Kathodenzerstäubung abgeschieden. Die untere Anpassungsschicht und optional die obere Anpassungsschicht enthält das Gettermaterial. Mindestens eine Anpassungsschicht innerhalb jeder funktionellen Schicht umfasst das Gettermaterial. Die zweite Anpassungsschicht der funktionellen Schicht kann optional ein Gettermaterial enthalten.

Das Target zur Abscheidung einer Anpassungsschicht mit Gettermaterial enthält 90 Gew.-% bis 99 Gew.-% zinkoxidbasierte Keramik und 1 Gew.-% bis 10 Gew.-% des Gettermaterials, bevorzugt 90 Gew.-% bis 98 Gew.-% zinkoxidbasierte Keramik und 2 Gew.-% bis 10 Gew.-% des Gettermaterials, besonders bevorzugt 90 Gew.-% bis 97 Gew.-% zinkoxidbasierte Keramik und 3 Gew.-% bis 10 Gew.-% des Gettermaterials, ganz besonders bevorzugt 93 Gew.-% bis 97 Gew.-% zinkoxidbasierte Keramik und 3 Gew.-% bis 7 Gew.-% des Gettermaterials, insbesondere 94 Gew.-% bis 96 Gew.-% zinkoxidbasierte Keramik und 4 Gew.-% bis 6 Gew.-% des Gettermaterials. Diese zinkoxidbasierte Keramik kann ihrerseits wiederum weitere oxidische Bestandteile, beispielsweise Aluminiumoxid, enthalten. In einer bevorzugten Ausführungsform enthält die zinkoxidbasierte Keramik 85 Gew.-% bis 100 Gew.-% Zinkoxid, besonders bevorzugt 95 Gew.-% bis 99 Gew.-% Zinkoxid sowie 1 Gew.-% bis 5 Gew.-% Aluminiumoxid. Ferner können herstellungsbedingte Beimengungen enthalten sein. Bevorzugt wird Titan als Gettermaterial verwendet. Bei Abscheidung einer Anpassungsschicht ohne Gettermaterial wird bevorzugt ein Target enthaltend 85 Gew.-% bis 100 Gew.-% Zinkoxid sowie herstellungsbedingte Beimengungen eingesetzt. Besonders bevorzugt enthält das Target 85 Gew.-% bis 99 Gew.-% Zinkoxid und 1 Gew.-% bis 15 Gew.-% Aluminiumoxid, insbesondere 95 Gew.-% bis 99 Gew.-% Zinkoxid und 1 Gew.-% bis 5 Gew.-% Aluminiumoxid sowie jeweils herstellungsbedingte Beimengungen. Die Abscheidung der oberen Anpassungsschicht und der unteren Anpassungsschicht erfolgt bevorzugt durch magnetfeldunterstützte Kathodenzerstäubung unter Verwendung eines Inertgases, beispielsweise Argon oder Krypton. Anpassungsschichten, die kein Gettermaterial enthalten können alternativ auch mittels metallischer Targets unter Zugabe von Sauerstoff als Reaktionsgas abgeschieden werden, wie nach dem Stand der Technik hinlänglich bekannt und beispielsweise in EP 2444381 A1 offenbart.

Die Schichtdicken der unteren Anpassungsschicht und der oberen Anpassungsschicht betragen bevorzugt von 3 nm bis 20 nm besonders bevorzugt von 4 nm bis 12 nm.

Sowohl die obere Anpassungsschicht als auch die untere Anpassungsschicht können ein Gettermaterial enthalten, wobei bevorzugt mindestens die untere Anpassungsschicht ein Gettermaterial umfasst. Die untere Anpassungsschicht mit Gettermaterial befindet sich unmittelbar unterhalb der elektrisch leitfähigen Schicht und dient insbesondere zur Stabilisierung der elektrisch leitfähigen Schicht gegen Oxidation. Dadurch verbessert sich die optische Qualität der elektrisch leitfähigen Beschichtung. Die obere Anpassungsschicht ist unmittelbar oberhalb der elektrisch leitfähigen Schicht aufgebracht.

Das transparente Substrat enthält bevorzugt Glas, besonders bevorzugt Flachglas, Floatglas, Quarzglas, Borosilikatglas, Kalk-Natron-Glas oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Beispiele geeigneter Gläser sind aus DE 697 31 268 T2, Seite 8, Absatz [0053], bekannt.

Die Dicke des transparenten Substrats kann breit variieren und so hervorragend den Erfordernissen im Einzelfall angepasst werden. Vorzugsweise werden Scheiben mit den Standardstärken von 1,0 mm bis 25 mm und bevorzugt von 1,4 mm bis 2,6 mm verwendet. Die Größe des transparenten Substrats kann breit variieren und richtet sich nach der erfindungsgemäßen Verwendung. Das transparente Substrat weist beispielsweise im Fahrzeugbau und Architekturbereich übliche Flächen von 200 cm² bis zu 4 m² auf.

Das transparente Substrat kann eine beliebige dreidimensionale Form aufweisen. Vorzugsweise hat die dreidimensionale Form keine Schattenzonen, so dass sie beispielsweise durch Kathodenzerstäubung beschichtet werden kann. Das transparente Substrat ist bevorzugt plan oder leicht oder stark in einer Richtung oder in mehreren Richtungen des Raumes gebogen. Das transparente Substrat kann farblos oder gefärbt sein.

In einer vorteilhaften Ausgestaltung der Erfindung ist das transparente Substrat über zumindest eine Laminierfolie mit einer zweiten Scheibe zu einer Verbundscheibe verbunden. Die erfindungsgemäße elektrisch leitfähige Beschichtung ist bevorzugt auf die der Laminierfolie zugewandten Oberfläche des transparenten Substrats aufgebracht. Dadurch wird die elektrisch leitfähige Beschichtung vorteilhaft vor Beschädigungen und Korrosion geschützt.

Die Verbundscheibe weist bevorzugt eine Gesamttransmission von größer 70 % auf.

Die Laminierfolie enthält bevorzugt thermoplastische Kunststoffe, beispielsweise Polyvinylbutyral (PVB), Ethylenvinylacetat (EVA), Polyurethan (PU), Polyethylenterephthalat (PET) oder mehrere Schichten davon, bevorzugt mit Dicken von 0,3 mm bis 0,9 mm.

Die zweite Scheibe enthält bevorzugt Glas, besonders bevorzugt Flachglas, Floatglas, Quarzglas, Borosilikatglas, Kalk-Natron-Glas oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Die zweite Scheibe weist bevorzugt eine Dicke von 1,0 mm bis 25 mm und besonders bevorzugt von 1,4 mm bis 2,6 mm auf.

Die elektrisch leitfähige Beschichtung erstreckt sich bevorzugt über die gesamte Oberfläche des transparenten Substrats, abzüglich eines umlaufenden rahmenförmigen beschichtungsfreien Bereichs mit einer Breite von 2 mm bis 20 mm, bevorzugt von 5 mm bis 10 mm. Der beschichtungsfreie Bereich wird bevorzugt durch die Laminierfolie oder einen Acrylatkleber als Dampfdiffusionssperre hermetisch versiegelt. Durch die Dampfdiffusionssperre wird die korrosionsempfindliche elektrisch leitfähige Beschichtung vor Feuchtigkeit und Luftsauerstoff geschützt. Ist die Verbundscheibe als Fahrzeugscheibe, beispielsweise als Windschutzscheibe vorgesehen, so bewirkt der umlaufende beschichtungsfreie Bereich zudem eine elektrische Isolierung zwischen der spannungsführenden Beschichtung und der Fahrzeugkarosserie.

Das transparente Substrat kann in zumindest einem weiteren Bereich beschichtungsfrei sein, der beispielsweise als Datenübertragungsfenster oder Kommunikationsfenster dient. Die transparente Scheibe ist in dem weiteren beschichtungsfreien Bereich für elektromagnetische und insbesondere infrarote Strahlung durchlässig.

Die elektrisch leitfähige Beschichtung kann direkt auf der Oberfläche des transparenten Substrats aufgebracht sein. Alternativ kann die elektrisch leitfähige Beschichtung auf eine Trägerfolie aufgebracht sein, die zwischen zwei Laminierfolien eingebettet ist. Die Trägerfolie enthält bevorzugt ein thermoplastisches Polymer, insbesondere Polyvinylbutyral (PVB), Ethylenvinylacetat (EVA), Polyurethan (PU), Polyethylenterephthalat (PET) oder Kombinationen davon.

Das transparente Substrat kann beispielsweise auch mit einer zweiten Scheibe über Abstandshalter zu einer Isolierverglasung verbunden sein. Das transparente Substrat kann auch mit mehr als einer weiteren Scheibe über Laminierfolien und/oder Abstandshalter verbunden sein. Ist das transparente Substrat mit einer oder mit mehreren weiteren Scheiben verbunden, so kann eine oder mehrere dieser weiteren Scheiben ebenfalls eine elektrisch leitfähige Beschichtung aufweisen.

In einer besonders vorteilhaften Ausführungsform ist die elektrisch leitfähige Beschichtung mit geeigneten Mitteln zum Anlegen einer Spannung ausgestattet und dadurch beheizbar. Alternativ kann die elektrisch leitfähige Beschichtung auch unbeheizt eingesetzt werden, beispielsweise zur Abschirmung von IR-Strahlung, wodurch die Erwärmung des Fahrzeuginnenraums durch direkte Sonneneinstrahlung verringert wird.

Bevorzugt ist die elektrisch leitfähige Beschichtung über Sammelleiter mit einer Spannungsquelle verbunden und eine an die elektrisch leitfähige Beschichtung angelegte Spannung weist einen Wert von 12 V bis 15 V auf. Die Sammelleiter, sogenannte bus bars, dienen der Übertragung elektrischer Leistung. Beispiele geeigneter Sammelleiter sind aus DE 103 33 618 B3 und EP 0 025 755 B1 bekannt.

Die Sammelleiter werden vorteilhaft durch Aufdrucken einer leitfähigen Paste hergestellt. Wird das transparente Substrat nach Aufbringen der elektrisch leitfähigen Beschichtung gebogen, so wird die leitfähige Paste bevorzugt vor dem Biegen und/oder beim Biegen des transparenten Substrats eingebrannt. Die leitfähige Paste enthält bevorzugt Silber-Partikel und Glasfritten. Die Schichtdicke der eingebrannten leitfähigen Paste beträgt bevorzugt von 5 µm bis 20 µm.

In einer alternativen Ausgestaltung werden dünne und schmale Metallfolienstreifen oder Metalldrähte als Sammelleiter verwendet, die bevorzugt Kupfer und/oder Aluminium enthalten, insbesondere werden Kupferfolienstreifen mit einer Dicke von bevorzugt 10 µm bis 200 µm, beispielsweise etwa 50 µm verwendet. Die Breite der Kupferfolienstreifen beträgt bevorzugt 1 mm bis 10 mm. Der elektrische Kontakt zwischen elektrisch leitfähiger Beschichtung und Sammelleiter kann beispielsweise durch Auflöten oder Kleben mit einem elektrisch leitfähigen Kleber hergestellt werden. Ist das transparente Substrat Teil eines Verbundglases, so können die Metallfolienstreifen oder Metalldrähte beim Zusammenlegen der Verbundschichten auf die elektrisch leitfähige Beschichtung aufgelegt werden. Im späteren Autoklavprozess wird durch Einwirkung von Wärme und Druck ein sicherer elektrischer Kontakt zwischen den Sammelleitern und der Beschichtung erreicht.

Als Zuleitung zur Kontaktierung von Sammelleitern im Innern von Verbundscheiben werden im Fahrzeugbereich üblicherweise Folienleiter verwendet. Beispiele für Folienleiter werden in DE 42 35 063 A1, DE 20 2004 019 286 U1 und DE 93 13 394 U1 beschrieben.

Flexible Folienleiter, mitunter auch Flachleiter oder Flachbandleiter genannt, bestehen bevorzugt aus einem verzinnten Kupferband mit einer Dicke von 0,03 mm bis 0,1 mm und einer Breite von 2 mm bis 16 mm. Kupfer hat sich für solche Leiterbahnen bewährt, da es eine gute elektrische Leitfähigkeit sowie eine gute Verarbeitbarkeit zu Folien besitzt. Gleichzeitig sind die Materialkosten niedrig. Es können auch andere elektrisch leitende Materialien verwendet werden, die sich zu Folien verarbeiten lassen. Beispiele hierfür sind Aluminium, Gold, Silber oder Zinn und Legierungen davon.

Das verzinnte Kupferband ist zur elektrischen Isolation und zur Stabilisierung auf ein Trägermaterial aus Kunststoff aufgebracht oder beidseitig mit diesem laminiert. Das Isolationsmaterial enthält in der Regel eine 0,025 mm bis 0,05 mm dicken Folie auf Polyimid-Basis. Andere Kunststoffe oder Materialien mit den erforderlichen isolierenden Eigenschaften können ebenfalls verwendet werden. In einem Folienleiterband können sich mehrere voneinander elektrisch isolierte, leitfähige Schichten befinden.

Folienleiter, die sich zur Kontaktierung von elektrisch leitfähigen Schichten in Verbundscheiben eignen, weisen lediglich eine Gesamtdicke von 0,3 mm auf. Derart dünne Folienleiter können ohne Schwierigkeiten zwischen den einzelnen Scheiben in der Laminierfolie eingebettet werden.

Alternativ können auch dünne Metalldrähte als Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

Die Erfindung umfasst weiter ein Verfahren zur Herstellung einer erfindungsgemäßen transparenten Scheibe mit elektrisch leitfähiger Beschichtung, wobei mindestens zwei funktionelle Schichten nacheinander auf ein transparentes Substrat aufgebracht werden und zum Aufbringen jeder funktionellen Schicht nacheinander zumindest
a) eine Schicht optisch hochbrechenden Materials mit einem Brechungsindex größer oder gleich 2,1,
b) eine Glättungsschicht, die zumindest ein nichtkristallines Oxid enthält,
c) eine untere Anpassungsschicht,
d) eine elektrisch leitfähige Schicht und
e) eine obere Anpassungsschicht
aufgebracht werden und wobei die untere Anpassungsschicht und/oder die obere Anpassungsschicht gleichzeitig mit einem darin enthaltenen Gettermaterial aufgebracht wird.

Die einzelnen Schichten werden durch an sich bekannte Verfahren, beispielsweise durch magnetfeldunterstützte Kathodenzerstäubung abgeschieden. Die Kathodenzerstäubung erfolgt in einer Schutzgasatmosphäre, beispielsweise aus Argon oder Krypton, beziehungsweise in einer Reaktivgasatmosphäre, beispielsweise durch Zugabe von Sauerstoff oder Stickstoff.

Die obere Anpassungsschicht und/oder die untere Anpassungsschicht werden sofern sie ein Gettermaterial enthalten durch magnetfeldunterstützte Kathodenzerstäubung unter Verwendung eines Inertgases abgeschieden. Als Target werden dabei keramische Targets verwendet. In einer bevorzugten Ausführungsform wird ein zinkoxidbasiertes keramisches Target verwendet, das mit einem Gettermaterial, bevorzugt mit Titan, dotiert ist. Metallische Targets sind im erfindungsgemäßen Verfahren zur Abscheidung von Anpassungsschichten mit Gettermaterial nicht verwendbar, da diese zur Erzeugung einer keramischen Schicht, wie beispielsweise Zinkoxid, in Gegenwart von Sauerstoff abgeschieden werden müssen und ein im Target enthaltenes Gettermaterial dabei oxidiert würde. Bei Einsatz eines keramischen Targets liegt Zink bereits in der oxidierten Form, als Zinkoxid vor, so dass dieses mit Argon oder Krypton als Inertgas abgeschieden werden kann. Das im Target enthaltende Gettermaterial, beispielsweise Titan, wird dabei nicht oxidiert.

Die obere Anpassungsschicht und/oder die obere Anpassungsschicht werden erfindungsgemäß durch Kathodenstrahlzerstäubung eines keramischen Targets enthaltend 3 Gew.-% bis 10 Gew.-%, bevorzugt 2 Gew.-% bis 8 Gew.-%, besonders bevorzugt 3 Gew.-% bis 7 Gew.-%, insbesondere 4 Gew.-% bis 6 Gew.-%, des Gettermaterials abgeschieden. Das keramische Target ist dabei vorzugsweise zinkoxid-basiert. In einer besonders bevorzugten Ausführungsform enthält die zinkoxidbasierte Keramik dabei 95 Gew.-% bis 99 Gew.-% ZnO und 1 Gew.-% bis 5 Gew.-% Al₂O₃. Diese zinkoxidbasierte Keramik bildet mit einem Anteil von 90 Gew.-% bis 100 Gew.-% den Hauptbestandteil des Targets zur Abscheidung der Anpassungsschichten. Soll die resultierende Anpassungsschicht ein Gettermaterial enthalten, so enthält das zu ihrer Abscheidung verwendete Target 90 Gew.-% bis 99 Gew.-% der zinkoxidbasierten Keramik sowie 1 Gew.-% bis 10 Gew.-% des Gettermaterials, bevorzugt 92 Gew.-% bis 98 Gew.-% der zinkoxidbasierten Keramik und 2 Gew.-% bis 8 Gew.-% des Gettermaterials, besonders bevorzugt 93 Gew.-% bis 97 Gew.-% der zinkoxidbasierten Keramik und 3 Gew.-% bis 7 Gew.-% des Gettermaterials.

Bevorzugt werden die erfindungsgemäßen Anpassungsschichten mit Gettermaterial bei einem Druck von 0,5 µbar bis 5 µbar unter Verwendung einer gepulsten Gleichspannungsquelle mit Argon als Inertgas abgeschieden. Besonders bevorzugt erfolgt die Abscheidung durch Multifrequenz-Kathodenzerstäubung bei 25 kHz bis 50 kHz unter Verwendung von zwei Targets, die während des Sputtervorgangs über eine entgegengesetzte periodisch wechselnde Ladung verfügen.

Die Schichtdicken der einzelnen Schichten mit den gewünschten Eigenschaften hinsichtlich Transmission, Flächenwiderstand und Farbwerten ergeben sich für den Fachmann in einfacher Weise durch Simulationen im Bereich der oben angegebenen Schichtdicken.

In einer vorteilhaften Ausführung der Erfindung wird die elektrisch leitfähige Beschichtung mit mindestens zwei Sammelleitern verbunden, das transparente Substrat und eine zweite Scheibe auf eine Temperatur von 500°C bis 700°C erhitzt und das transparente Substrat und die zweite Scheibe mit einer Laminierfolie flächendeckend verbunden. Das Erhitzen der Scheibe kann im Rahmen eines Biegeprozesses erfolgen. Die elektrisch leitfähige Beschichtung muss insbesondere geeignet sein, den Biegeprozess und/oder den Verbundprozess ohne Beschädigungen zu überstehen. Die Eigenschaften, insbesondere der Flächenwiderstand der oben beschriebenen elektrisch leitfähigen Beschichtung verbessern sich regelmäßig durch die Erhitzung.

Die Erfindung umfasst weiter die Verwendung der erfindungsgemäßen transparenten Scheibe als Scheibe oder als Bestandteil einer Scheibe, insbesondere als Bestandteil einer Isolierverglasung oder einer Verbundscheibe, in Gebäuden oder in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheibe und/oder Dachscheibe oder als Bestandteil einer Windschutzscheibe, Heckscheibe, Seitenscheibe und/oder Dachscheibe.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
Figur 1 einen Querschnitt durch eine Ausgestaltung der erfindungsgemäßen transparenten Scheibe mit elektrisch leitfähiger Beschichtung.
Figur 2 eine Draufsicht auf eine erfindungsgemäße transparente Scheibe als Teil einer Verbundscheibe.
Figur 3 einen Schnitt A-A' durch die Verbundscheibe gemäß Figur 2.
Figur 4 ein Fließdiagramm des erfindungsgemäßen Verfahrens.

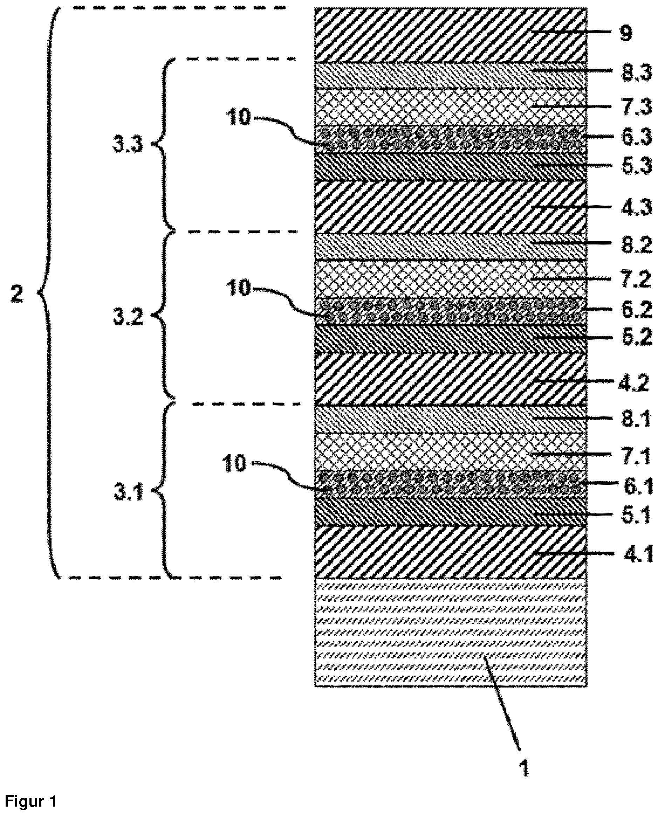

Fig. 1 zeigt einen Querschnitt durch eine Ausgestaltung der erfindungsgemäßen transparenten Scheibe mit elektrisch leitfähiger Beschichtung mit dem transparenten Substrat (1) und der elektrisch leitfähigen Beschichtung (2). Das Substrat (1) enthält Floatglas und weist eine Dicke von 2,1 mm auf. Die elektrisch leitfähige Beschichtung (2) enthält drei funktionelle Schichten (3), umfassend eine erste funktionelle Schicht (3.1), eine zweite funktionelle Schicht (3.2) und eine dritte funktionelle Schicht (3.3), die flächendeckend übereinander angeordnet sind. Jede funktionelle Schicht (3) umfasst
- eine Schicht optisch hochbrechenden Materials (4), jeweils als erste Schicht optisch hochbrechenden Materials (4.1), zweite Schicht optisch hochbrechenden Materials (4.2) und dritte Schicht optisch hochbrechenden Materials (4.3) bezeichnet,
- eine Glättungsschicht (5), jeweils als erste Glättungsschicht (5.1), zweite Glättungsschicht (5.2) und dritte Glättungsschicht (5.3) bezeichnet,
- eine untere Anpassungsschicht (6), jeweils als erste untere Anpassungsschicht (6.1), zweite untere Anpassungsschicht (6.2) und dritte untere Anpassungsschicht (6.3) bezeichnet,
- ein Gettermaterial (10) enthalten in der ersten unteren Anpassungsschicht (6.1), zweiten unteren Anpassungsschicht (6.2) und dritten unteren Anpassungsschicht (6.3),
- eine elektrisch leitfähige Schicht (7), jeweils als erste elektrisch leitfähige Schicht (7.1), zweite elektrisch leitfähige Schicht (7.2) und dritte elektrisch leitfähige Schicht (7.3) bezeichnet,
- eine obere Anpassungsschicht (8), jeweils als erste obere Anpassungsschicht (8.1), zweite obere Anpassungsschicht (8.2) und dritte obere Anpassungsschicht (8.3) bezeichnet.

Die Schichten sind in der angegebenen Reihenfolge mit wachsendem Abstand zum transparenten Substrat (1) angeordnet. Oberhalb der dritten funktionellen Schicht (3.3) ist eine Abdeckschicht (9) angeordnet. Die genaue Schichtfolge der funktionellen Schichten (3.1, 3.2, 3.3) mit geeigneten Materialien und beispielhaften Schichtdicken entspricht von unten nach oben auf Glas mit einer Dicke von 2,1 mm als transparentes Substrat (1):
- aluminiumdotiertes Silizium-Zirkonium-Mischnitrid (SiZrNₓ:Al) als Schicht optisch hochbrechenden Materials (4) mit einer Dicke von 28 nm (4.1), 59 nm (4.2) oder 60 nm (4.3),
- antimondotiertes Zinn-Zink-Mischoxid (SnZnOₓ:Sb) mit einer Dicke von 6 nm als Glättungsschichten (5),
- titandotiertes Zink-Aluminium-Oxid (ZnO:Al₂O₃:Ti) mit einer Dicke von 10 nm als untere Anpassungsschichten (6) mit Gettermaterial (10),
- Silberschicht mit einer Dicke von 18 nm als elektrisch leitfähige Schichten (7),
- Zink-Aluminium-Oxid (ZnO:Al₂O₃) mit einer Dicke von 5 nm als obere Anpassungsschichten (8).

Dabei ist die erste funktionelle Schicht (3.1) direkt auf dem transparenten Substrat (1) aufgebracht, während die zweite funktionelle Schicht (3.2) auf der ersten funktionellen Schicht und die dritte funktionelle Schicht (3.3) auf der zweiten funktionellen Schicht (3.2) angeordnet ist.

Die oberste Schicht der elektrisch leitfähigen Beschichtung (2) bildet eine Abdeckschicht (9), die auf der dritten funktionellen Schicht (3.3) aufgetragen ist. Die Abdeckschicht (9) besteht aus aluminiumdotiertem Silizium-Zirkonium-Mischnitrid (SiZrNₓ:Al) mit einer Schichtdicke von 40 nm.

Die einzelnen Schichten der elektrisch leitfähigen Beschichtung (2) wurden durch Kathodenstrahlzerstäubung abgeschieden. Das Target zur Abscheidung der unteren Anpassungsschichten (6) enthielt 95 Gew.-% einer zinkoxidbasierten Keramik und 5 Gew.-% Titan. Die zinkoxidbasierte Keramik enthielt dabei 98 Gew.-% ZnO und 2 Gew.-% Al₂O₃. Das Target zur Abscheidung der oberen Anpassungsschichten (8) bestand aus dieser zinkoxidbasierten Keramik enthaltend 98 Gew.-% ZnO und 2 Gew.-% Al₂O₃. Die Abscheidung der Anpassungsschichten (6, 8) erfolgte mittels Kathodenzerstäubung in Gegenwart von Argon. Das Target zur Abscheidung der Glättungsschichten (5) enthielt 68 Gew.-% Zinn, 30 Gew.-% Zink und 2 Gew.-% Antimon. Die Abscheidung erfolgte unter Zugabe von Sauerstoff als Reaktionsgas während der Kathodenzerstäubung. Das Target zur Abscheidung der Schichten optisch hochbrechenden Materials (4) sowie der Abdeckschicht (9) enthielt 52,9 Gew.-% Silizium, 43,8 Gew.-% Zirkonium und 3,3 Gew.-% Aluminium. Die Abscheidung erfolgte unter Zugabe von Stickstoff als Reaktionsgas während der Kathodenzerstäubung.

Durch die erfindungsgemäße Ausgestaltung der elektrisch leitfähigen Beschichtung (2) mit unteren Anpassungsschichten (6) enthaltend ein Gettermaterial (10) wird vorteilhaft ein im Vergleich zum Stand der Technik verringerter Flächenwiderstand und damit eine verbesserte spezifische Heizleistung erreicht. Die Kombination von unterer Anpassungsschicht (6) und Gettermaterial (10) macht die Verwendung einer zusätzlichen Blockerschicht zum Schutz der elektrisch leitfähigen Schicht vor Sauerstoff obsolet. Somit steht die untere Anpassungsschicht (6) in direktem Kontakt zur silberhaltigen elektrisch leitfähigen Schicht (7), wodurch ein kristallines Aufwachsen des Silbers gewährleistet ist. Diese verbesserte Kristallinität des Silbers führt zu der gewünschten Reduzierung des Flächenwiderstands der erfindungsgemäßen elektrisch leitfähigen Beschichtung. Die optischen Eigenschaften der erfindungsgemäßen transparenten Scheibe mit elektrisch leitfähiger Beschichtung genügen dabei den gesetzlichen Anforderungen an Verglasungen im Fahrzeugbau.

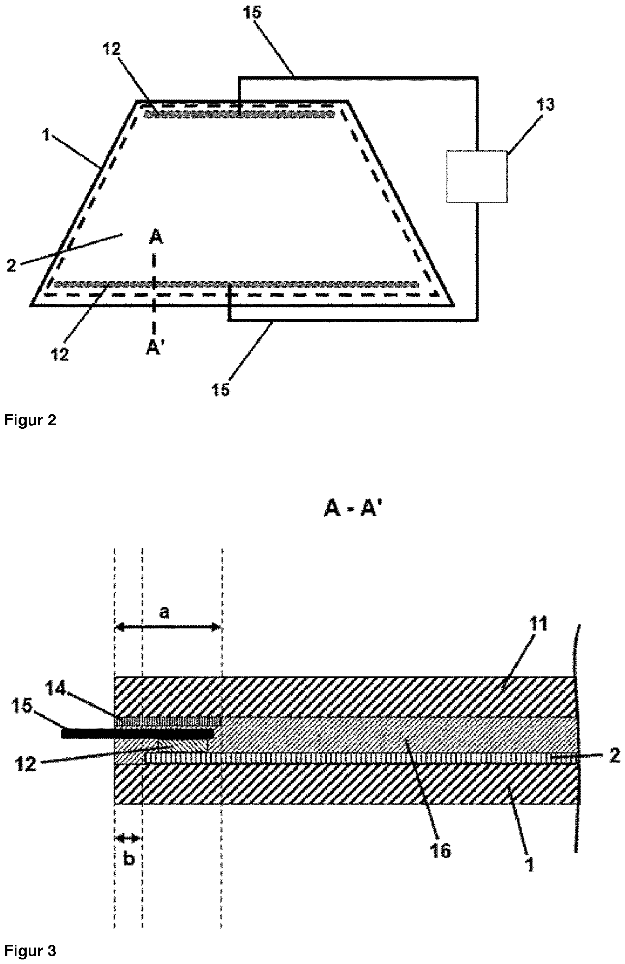

Figur 2 und Figur 3 zeigen je ein Detail einer erfindungsgemäßen transparenten Scheibe mit elektrisch leitfähiger Beschichtung (2) als Teil einer Verbundscheibe. Die Verbundscheibe ist als Windschutzscheibe eines Personenkraftwagens vorgesehen. Das transparente Substrat (1) ist über eine Laminierfolie (16) mit einer zweiten Scheibe (11) verbunden. Figur 2 zeigt eine Draufsicht auf die von der Laminierfolie (16) abgewandte Oberfläche des transparenten Substrats (1). Das transparente Substrat (1) ist die dem Innenraum des Personenkraftwagens zugewandte Scheibe. Das transparente Substrat (1) und die zweite Scheibe (11) enthalten Floatglas und weisen eine Dicke von jeweils 2,1 mm auf. Die Laminierfolie (16) enthält Polyvinylbutyral (PVB) und weist eine Dicke von 0,76 mm auf.

Auf die zur Laminierfolie (16) hingewandte Oberfläche des transparenten Substrats (1) ist eine elektrisch leitfähige Beschichtung (2) aufgebracht. Die elektrisch leitfähige Beschichtung (2) erstreckt sich über die gesamte Oberfläche des transparenten Substrats (1) abzüglich eines umlaufenden rahmenförmigen beschichtungsfreien Bereichs mit einer Breite b von 8 mm. Der beschichtungsfreie Bereich dient der elektrischen Isolierung zwischen der spannungsführenden elektrisch leitfähigen Beschichtung (2) und der Fahrzeugkarosserie. Der beschichtungsfreie Bereich ist durch Verkleben mit der Laminierfolie (16) hermetisch versiegelt, um die elektrisch leitfähige Beschichtung (2) vor Beschädigungen und Korrosion zu schützen.

Am äußeren oberen und unteren Rand des transparenten Substrats (1) ist jeweils ein Sammelleiter (12) angeordnet. Die Sammelleiter (12) wurden mittels einer leitfähigen Silberpaste auf die elektrisch leitfähige Beschichtung (2) aufgedruckt und eingebrannt. Die Schichtdicke der eingebrannten Silber-Paste beträgt 15 µm. Die Sammelleiter (12) sind elektrisch leitend mit den darunterliegenden Bereichen der elektrisch leitfähigen Beschichtung (2) verbunden.

Die Zuleitungen (15) bestehen aus verzinnten Kupferfolien mit einer Breite von 10 mm und einer Dicke von 0,3 mm. Jede Zuleitung (15) ist jeweils mit einem der Sammelleiter (12) verlötet. Die elektrisch leitfähige Beschichtung (2) ist über die Sammelleiter (12) und die Zuleitungen (15) mit einer Spannungsquelle (13) verbunden. Die Spannungsquelle (13) ist die Bordspannung von 14 V eines Kraftfahrzeugs.

Auf der zweiten Scheibe (11) ist am Rand der zur Laminierfolie (16) hingewandten Oberfläche eine opake Farbschicht mit einer Breite a von 20 mm als Abdeckdruck (14) rahmenförmig aufgebracht. Der Abdeckdruck (14) verdeckt die Sicht auf den Klebestrang, mit dem die Verbundscheibe in die Fahrzeugkarosserie eingeklebt wird. Der Abdeckdruck (14) dient gleichzeitig als Schutz des Klebers vor UV-Strahlung und damit als Schutz vor vorzeitiger Alterung des Klebers. Des Weiteren werden die Sammelleiter (12) und die Zuleitungen (15) durch den Abdeckdruck (14) verdeckt.

Figur 3 zeigt einen Schnitt entlang A-A' durch die Verbundscheibe gemäß Figur 2 im Bereich der unteren Kante. Zu sehen ist das transparente Substrat (1) mit der elektrisch leitfähigen Beschichtung (2), die zweite Scheibe (11), die Laminierfolie (16), ein Sammelleiter (12), eine Zuleitung (15) sowie der Abdeckdruck (14).

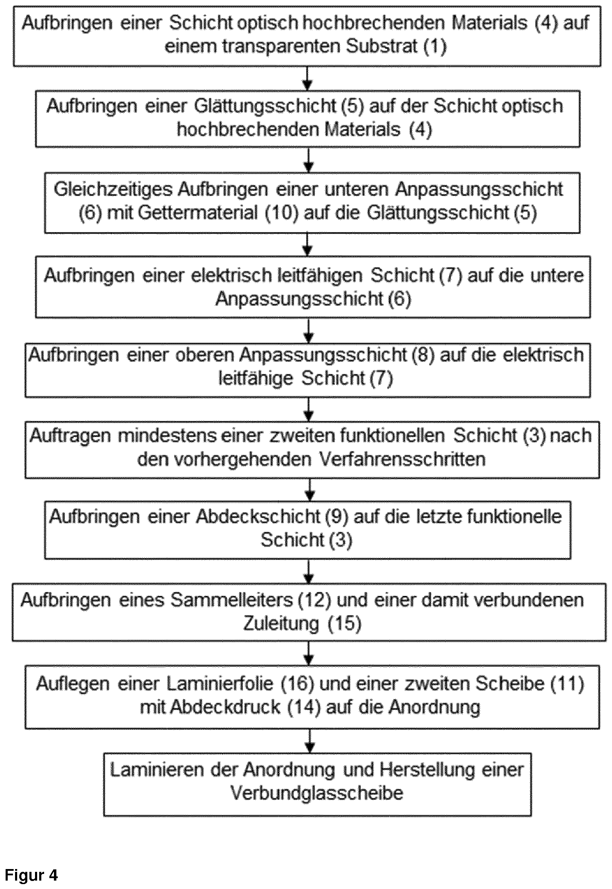

Figur 4 zeigt ein Fließdiagramm des erfindungsgemäßen Verfahrens. In einem ersten Schritt wird eine Schicht optisch hochbrechenden Materials auf einem transparenten Substrat abgeschieden und danach eine Glättungsschicht auf dieser aufgebracht. Auf der Glättungsschicht wird eine untere Anpassungsschicht mit Gettermaterial abgeschieden, wobei das Gettermaterial homogen in der Anpassungsschicht verteilt ist und in einem Schritt mit dieser aufgetragen wird. Auf der unteren Anpassungsschicht wird eine elektrisch leitfähige Schicht aufgebracht und darauf eine obere Anpassungsschicht. Somit ergibt sich eine erste funktionelle Schicht bestehend aus einer Schicht optisch hochbrechenden Materials, einer Glättungsschicht, einer unteren Anpassungsschicht mit Gettermaterial, einer elektrisch leitfähigen Schicht und einer oberen Anpassungsschicht. Auf diese erste funktionelle Schicht wird mindestens eine zweite funktionelle Schicht, höchstens vier weitere funktionelle Schichten, aufgetragen. Das Schichtsystem wird durch Abscheidung einer Abdeckschicht auf die oberste funktionelle Schicht abgeschlossen. Im Anschluss wird das Schichtsystem durch Anbringen eines Sammelleiters mit Zuleitung elektrisch kontaktiert. Auf die Anordnung werden eine Laminierfolie und eine zweiten Scheibe mit Abdeckdruck gelegt und die Anordnung wird zur Herstellung einer Verbundglasscheibe laminiert.

### Bezugszeichenliste

- 1: transparentes Substrat
- 2: elektrisch leitfähige Beschichtung
- 3: funktionelle Schicht
- 3.1: erste funktionelle Schicht
- 3.2: zweite funktionelle Schicht
- 3.3: dritte funktionelle Schicht
- 4: Schicht optisch hochbrechenden Materials
- 4.1: erste Schicht optisch hochbrechenden Materials
- 4.2: zweite Schicht optisch hochbrechenden Materials
- 4.3: dritte Schicht optisch hochbrechenden Materials
- 5: Glättungsschicht
- 5.1: erste Glättungsschicht
- 5.2: zweite Glättungsschicht
- 5.3: dritte Glättungsschicht
- 6: untere Anpassungsschicht
- 6.1: erste untere Anpassungsschicht
- 6.2: zweite untere Anpassungsschicht
- 6.3: dritte untere Anpassungsschicht
- 7: elektrisch leitfähige Schicht
- 7.1: erste elektrisch leitfähige Schicht
- 7.2: zweite elektrisch leitfähige Schicht
- 7.3: dritte elektrisch leitfähige Schicht
- 8: obere Anpassungsschicht
- 8.1: erste obere Anpassungsschicht
- 8.2: zweite obere Anpassungsschicht
- 8.3: dritte obere Anpassungsschicht
- 9: Abdeckschicht
- 10: Gettermaterial
- 11: zweite Scheibe
- 12: Sammelleiter
- 13: Spannungsquelle
- 14: Abdeckdruck
- 15: Zuleitung
- 16: Laminierfolie
- a: Breite des durch den Abdeckdruck (14) abgedeckten Bereichs
- b: Breite des beschichtungsfreien Bereichs

- A-A': Schnittlinie

## Patentansprüche

1. Transparente Scheibe, umfassend mindestens ein transparentes Substrat (1) und auf mindestens einer Oberfläche des transparenten Substrats (1) mindestens eine elektrisch leitfähige Beschichtung (2), wobei
- die elektrisch leitfähige Beschichtung (2) mindestens zwei übereinander angeordnete funktionelle Schichten (3) aufweist und jede funktionelle Schicht (3) mindestens
- eine Schicht optisch hochbrechenden Materials (4) mit einem Brechungsindex größer oder gleich 2,1,
- oberhalb der Schicht optisch hochbrechenden Materials (4) eine Glättungsschicht (5), die zumindest ein nichtkristallines Oxid enthält,
- oberhalb der Glättungsschicht (5) eine untere Anpassungsschicht (6),
- oberhalb der unteren Anpassungsschicht (6) eine elektrisch leitfähige Schicht (7) und
- oberhalb der elektrisch leitfähigen Schicht (7) eine obere Anpassungsschicht (8) umfasst,
- die untere Anpassungsschicht (6) und optional die obere Anpassungsschicht (8) ein im gesamten Schichtquerschnitt homogen verteiltes Gettermaterial (10) aus der Gruppe bestehend aus Niob, Titan, Barium, Magnesium, Tantal, Zirconium, Thorium, Palladium, Platin und Legierungen davon in einer Konzentration von 3 Gew.-% bis 10 Gew.-% enthält und
- die das Gettermaterial (10) enthaltende untere Anpassungsschicht (6) in direktem Kontakt zur elektrisch leitfähigen Schicht (7) steht.

2. Transparente Scheibe nach Anspruch 1, wobei die untere Anpassungsschicht (6) und/oder die obere Anpassungsschicht (8) das Gettermaterial (10) in einer Konzentration von 3 Gew.-% bis 7 Gew.-%, insbesondere 4 Gew.-% bis 6 Gew.-% enthält.

3. Transparente Scheibe nach Anspruch 1 oder 2, wobei das Gettermaterial (10) Titan enthält.

4. Transparente Scheibe nach einem der Ansprüche 1 bis 3, wobei die Gesamtschichtdicke aller elektrisch leitfähigen Schichten (7) von 32 nm bis 75 nm, bevorzugt von 50 nm bis 60 nm, beträgt.

5. Transparente Scheibe nach einem der Ansprüche 1 bis 4, wobei die Schicht optisch hochbrechenden Materials (4) zumindest ein Silizium-Metall-Mischnitrid, bevorzugt ein Silizium-Zirkonium-Mischnitrid, wie aluminium-dotiertes Silizium-Zirkonium-Mischnitrid enthält und jede zwischen zwei elektrisch leitfähigen Schichten (7) angeordnete Schicht optisch hochbrechenden Materials (4) eine Dicke von 35 nm bis 70 nm, bevorzugt von 45 nm bis 60 nm aufweist.

6. Transparente Scheibe nach einem der Ansprüche 1 bis 5, wobei die Glättungsschicht (5) zumindest ein nichtkristallines Mischoxid, bevorzugt ein Zinn-Zink-Mischoxid, wie Antimon-dotiertes Zinn-Zink-Mischoxid enthält und bevorzugt eine Dicke von 3 nm bis 20 nm, besonders bevorzugt von 4 nm bis 12 nm aufweist.

7. Transparente Scheibe nach einem der Ansprüche 1 bis 6, wobei die elektrisch leitfähige Schicht (7) zumindest Silber oder eine silberhaltige Legierung enthält und bevorzugt eine Schichtdicke von 8 nm bis 25 nm, besonders bevorzugt von 10 nm bis 20 nm aufweist.

8. Transparente Scheibe nach einem der Ansprüche 1 bis 7, wobei die untere Anpassungsschicht (6) und/oder die obere Anpassungsschicht (8) Zinkoxid ZnO_{1-δ} mit 0 < δ < 0,01 enthält und bevorzugt eine Dicke von 3 nm bis 20 nm, besonders bevorzugt von 4 nm bis 12 nm aufweist.

9. Transparente Scheibe nach einem der Ansprüche 1 bis 8, wobei oberhalb der obersten funktionellen Schicht (3) eine Abdeckschicht (9) angeordnet ist und wobei die Abdeckschicht (9) bevorzugt zumindest ein optisch hochbrechendes Material mit einem Brechungsindex größer oder gleich 2,1 enthält, besonders bevorzugt ein Silizium-Metall-Mischnitrid, insbesondere Silizium-Zirkonium-Mischnitrid, wie aluminium-dotiertes Silizium-Zirkonium-Mischnitrid.

10. Transparente Scheibe nach einem der Ansprüche 1 bis 9, wobei das transparente Substrat (1) über zumindest eine Laminierfolie (16) mit einer zweiten Scheibe (11) zu einer Verbundscheibe verbunden ist und wobei die Gesamttransmission der Verbundscheibe bevorzugt größer 70 % beträgt.

11. Verfahren zur Herstellung einer transparenten Scheibe mit elektrisch leitfähiger Beschichtung (2) nach einem der Ansprüche 1 bis 10, wobei mindestens zwei funktionelle Schichten (3) nacheinander auf ein transparentes Substrat (1) aufgebracht werden und zum Aufbringen jeder funktionellen Schicht (3) nacheinander zumindest
a) eine Schicht optisch hochbrechenden Materials (4) mit einem Brechungsindex größer oder gleich 2,1,
b) eine Glättungsschicht (5), die zumindest ein nichtkristallines Oxid enthält,
c) eine untere Anpassungsschicht (6),
d) eine elektrisch leitfähige Schicht (7) und
e) eine obere Anpassungsschicht (8)
aufgebracht werden und wobei die untere Anpassungsschicht (6) und/oder die obere Anpassungsschicht (8) gleichzeitig mit einem darin enthaltenen Gettermaterial (10) aufgebracht wird, wobei die untere Anpassungsschicht (6) und/oder die obere Anpassungsschicht (8) durch Kathodenstrahlzerstäubung eines keramischen Targets enthaltend 3 Gew.-% bis 10 Gew.-% des Gettermaterials (10) abgeschieden werden.

12. Verfahren nach Anspruch 11, wobei die untere Anpassungsschicht (6) und/oder die obere Anpassungsschicht (8) durch Kathodenstrahlzerstäubung eines keramischen Targets enthaltend 3 Gew.-% bis 7 Gew.-%, insbesondere 4 Gew.-% bis 6 Gew.-% des Gettermaterials (10) abgeschieden werden.

13. Verfahren nach Anspruch 11 oder 12, wobei
a) die elektrisch leitfähige Beschichtung (2) mit mindestens zwei Sammelleitern (12) verbunden wird,
b) das transparente Substrat (1) und eine zweite Scheibe (11) auf eine Temperatur von 500°C bis 700°C erhitzt werden und
c) danach das transparente Substrat (1) und die zweite Scheibe (11) mit einer Laminierfolie (16) flächendeckend verbunden werden.

14. Verwendung der transparenten Scheibe nach einem der Ansprüche 1 bis 10 als Scheibe oder als Bestandteil einer Scheibe, insbesondere als Bestandteil einer Isolierverglasung oder einer Verbundscheibe, in Gebäuden oder in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheibe und/oder Dachscheibe.

## Claims

1. Transparent pane, comprising at least one transparent substrate (1) and at least one electrically conductive coating (2) on at least one surface of the transparent substrate (1), wherein
- the electrically conductive coating (2) has at least two functional layers (3) arranged one above the other and each functional layer (3) comprises at least
- one layer of an optically highly refractive material (4) with a refractive index greater than or equal to 2.1,
- above the layer of an optically highly refractive material (4), a smoothing layer (5) that contains at least one non-crystalline oxide,
- above the smoothing layer (5), a lower matching layer (6),
- above the lower matching layer (6), an electrically conductive layer (7), and
- above the electrically conductive layer (7), an upper matching layer (8),
- the lower matching layer (6) and optionally the upper matching layer (8) contains a getter material (10) from the group consisting of niobium, titanium, barium, magnesium, tantalum, zirconium, thorium, palladium, platinum, and alloys thereof in a concentration from 3 wt.-% to 10 wt.-%, which is homogeneously distributed in the entire cross-section of the layer, and
- the lower matching layer (6) containing the getter material (10) is in direct contact with the electrically conductive layer (7).

2. Transparent pane according to claim 1, wherein the lower matching layer (6) and/or the upper matching layer (8) contains the getter material (10) in a concentration from 3 wt.-% to 7 wt.-%, in particular 4 wt.-% to 6 wt.-%.

3. Transparent pane according to claim 1 or 2, wherein the getter material (10) contains titanium.

4. Transparent pane according to one of claims 1 through 3, wherein the total layer thickness of all electrically conductive layers (7) is from 32 nm to 75 nm, preferably from 50 nm to 60 nm.

5. Transparent pane according to one of claims 1 through 4, wherein the layer of an optically highly refractive material (4) contains at least one mixed silicon/metal nitride, preferably a mixed silicon/zirconium nitride, such as aluminum-doped mixed silicon/zirconium nitride, and each layer of an optically highly refractive material (4) arranged between two electrically conductive layers (7) has a thickness from 35 nm to 70 nm, preferably from 45 nm to 60 nm.

6. Transparent pane according to one of claims 1 through 5, wherein the smoothing layer (5) contains at least one non-crystalline mixed oxide, preferably a mixed tin/zinc oxide, such as antimony-doped mixed tin/zinc oxide, and preferably has a thickness from 3 nm to 20 nm, particularly preferably from 4 nm to 12 nm.

7. Transparent pane according to one of claims 1 through 6, wherein the electrically conductive layer (7) contains at least silver or a silver-containing alloy, and preferably has a layer thickness from 8 nm to 25 nm, particularly preferably from 10 nm to 20 nm.

8. Transparent pane according to one of claims 1 through 7, wherein the lower matching layer (6) and/or the upper matching layer (8) contains zinc oxide ZnO_{1-δ} with 0 < δ < 0.01 and preferably has a thickness from 3 nm to 20 nm, particularly preferably from 4 nm to 12 nm.

9. Transparent pane according to one of claims 1 through 8, wherein a cover layer (9) is arranged above the uppermost functional layer (3) and wherein the cover layer (9) preferably contains at least one optically highly refractive material with a refractive index greater than or equal to 2.1, particularly preferably a mixed silicon/metal nitride, in particular mixed silicon/zirconium nitride, such as aluminum-doped mixed silicon/zirconium nitride.

10. Transparent pane according to one of claims 1 through 9, wherein the transparent substrate (1) is bonded via at least one laminating film (16) to a second pane (11) to form a composite pane and wherein the total transmittance of the composite pane is preferably greater than 70 %.

11. Method for producing a transparent pane with an electrically conductive coating (2) according to one of claims 1 through 10, wherein at least two functional layers (3) are applied one after another on a transparent substrate (1) and for applying each functional layer (3) one after another at least
a) one layer of an optically highly refractive material (4) with a refractive index greater than or equal to 2.1,
b) a smoothing layer (5) that contains at least one non-crystalline oxide,
c) a lower matching layer (6),
d) an electrically conductive layer (7), and
e) an upper matching layer (8)
are applied and wherein the lower matching layer (6) and/or the upper matching layer (8) are applied simultaneously with a getter material (10) contained therein, wherein the lower matching layer (6) and/or the upper matching layer (8) are deposited by cathode ray sputtering of a ceramic target containing 3 wt.-% to 10 wt.-% of the getter material (10).

12. Method according to claim 11, wherein the lower matching layer (6) and/or the upper matching layer (8) are deposited by cathode ray sputtering of a ceramic target containing 3 wt.-% to 7 wt.-%, in particular 4 wt.-% to 6 wt.-% of the getter material (10).

13. Method according to claim 11 or 12, wherein
a) the electrically conductive coating (2) is connected to at least two busbars (12),
b) the transparent substrate (1) and a second pane (11) are heated to a temperature from 500°C to 700°C, and
c) after that the transparent substrate (1) and the second pane (11) are congruently bonded to a laminating film (16).

14. Use of the transparent pane according to one of claims 1 through 10 as a pane or as a component of a pane, in particular as a component of an insulating glazing unit or a composite pane, in buildings or in means of transportation for travel on land, in the air, or on water, in particular in motor vehicles, for example, as a windshield, rear window, side window, and/or roof pane.

## Revendications

1. Vitre transparente comprenant au moins un substrat transparent (1) et, sur au moins une surface du substrat transparent (1), au moins un revêtement électriquement conducteur (2), où
- le revêtement électriquement conducteur (2) comprend au moins deux couches fonctionnelles (3) disposées l'une au-dessus de l'autre et chaque couche fonctionnelle (3) contient au moins
- une couche de matériau optique à haute réfraction (4) ayant un indice de réfraction égal ou supérieur à 2,1,
- au-dessus de la couche de matériau optique à haute réfraction (4), une couche de lissage (5) contenant au moins un oxyde non cristallin,
et contient
- au-dessus de la couche de lissage (5), une couche d'adaptation inférieure (6),
- au-dessus de la couche d'adaptation inférieure (6), une couche électriquement conductrice (7) et
- au-dessus de la couche électriquement conductrice (7) une couche d'adaptation supérieure (8),
- la couche d'adaptation inférieure (6) et éventuellement la couche d'adaptation supérieure (8) contiennent un matériau getter (10) réparti de manière homogène sur toute la section transversale de la couche, du groupe constitué par le niobium, le titane, le baryum, le magnésium, le tantale, le zirconium, le thorium, le palladium, le platine et des alliages de ceux-ci, à une concentration de 3 % à 10 % en poids et
- la couche d'adaptation inférieure (6) contenant le matériau getter (10) est en contact direct avec la couche électriquement conductrice (7).

2. Vitre transparente selon la revendication 1, où la couche d'adaptation inférieure (6) et/ou la couche d'adaptation supérieure (8) contient le matériau getter (10) dans une concentration de 3 % en poids à 7 % en poids, en particulier de 4 % en poids à 6 % en poids.

3. Vitre transparente selon la revendication 1 ou 2, où le matériau getter (10) contient du titane.

4. Vitre transparente selon l'une quelconque des revendications 1 à 3, où l'épaisseur totale de toutes les couches électriquement conductrices (7) est de 32 nm à 75 nm, de préférence de 50 nm à 60 nm.

5. Vitre transparente selon l'une des revendications 1 à 4, où la couche de matériau optique à haute réfraction (4) contient au moins un nitrure mixte silicium-métal, de préférence un nitrure mixte silicium-zirconium, tel qu'un nitrure mixte silicium-zirconium dopé à l'aluminium, et chaque couche de matériau optique à haute réfraction (4) disposée entre deux couches électriquement conductrices (7) présente une épaisseur de 35 nm à 70 nm, de préférence de 45 nm à 60 nm.

6. Vitre transparente selon l'une quelconque des revendications 1 à 5, où la couche de lissage (5) contient au moins un oxyde mixte non cristallin, de préférence un oxyde mixte étain-zinc, tel qu'un oxyde mixte étain-zinc dopé à l'antimoine, et présente de préférence une épaisseur de 3 nm à 20 nm, en particulier de 4 nm à 12 nm.

7. Vitre transparente selon l'une quelconque des revendications 1 à 6, où la couche électriquement conductrice (7) contient au moins de l'argent ou un alliage contenant de l'argent et présente de préférence une épaisseur de couche de 8 nm à 25 nm, de manière particulièrement préférée de 10 nm à 20 nm.

8. Vitre transparente selon l'une quelconque des revendications 1 à 7, où la couche d'adaptation inférieure (6) et/ou la couche d'adaptation supérieure (8) contient de l'oxyde de zinc ZnO_{1-δ} avec 0 < δ < 0,01 et présente de préférence une épaisseur de 3 nm à 20 nm, de manière particulièrement préférée de 4 nm à 12 nm.

9. Vitre transparente selon l'une des revendications 1 à 8, où une couche de recouvrement (9) est disposée au-dessus de la couche fonctionnelle supérieure (3) et où la couche de recouvrement (9) contient de préférence au moins un matériau hautement réfringent ayant un indice de réfraction supérieure ou égal à 2,1, en particulier de préférence un nitrure mixte silicium-métal, en particulier un nitrure mixte silicium-zirconium, tel qu'un nitrure mixte silicium-zirconium dopé à l'aluminium.

10. Vitre transparente selon l'une des revendications 1 à 9, où le substrat transparent (1) est relié à une deuxième vitre (11) par d'au moins un film de stratification (16) pour former une vitre composite et où la transmission totale de la vitre composite est de préférence supérieure à 70%.

11. Procédé de fabrication d'une vitre transparente avec un revêtement électriquement conducteur (2) selon l'une des revendications 1 à 10, où au moins deux couches fonctionnelles (3) sont appliquées successivement sur un substrat transparent (1) et, pour l'application de chaque couche fonctionnelle (3) successivement, au moins
a) une couche de matériau optique à haute réfraction (4) ayant un indice de réfraction égal ou supérieur à 2,1,
b) une couche de lissage (5) contenant au moins un oxyde non cristallin,
c) une couche d'adaptation inférieure (6),
d) une couche électriquement conductrice (7) ; et
e) une couche d'adaptation supérieure (8)
sont appliquées
et où la couche d'adaptation inférieure (6) et/ou la couche d'adaptation supérieure (8) est appliquée simultanément avec un matériau getter (10) contenu dans celle-ci, où la couche d'adaptation inférieure (6) et/ou la couche d'adaptation supérieure (8) est/sont déposée(s) par pulvérisation cathodique d'une cible céramique contenant 3 % en poids à 10 % en poids du matériau getter (10).

12. Procédé selon la revendication 11, où la couche d'adaptation inférieure (6) et/ou la couche d'adaptation supérieure (8) sont déposées par dépoussiérage aux rayons cathodiques d'une cible céramique contenant 3 % en poids à 7 % en poids, en particulier 4 % en poids à 6 % en poids du matériau getter (10).

13. Procédé selon la revendication 11 ou 12, où
a) le revêtement électriquement conducteur (2) est relié à au moins deux conducteurs collecteurs (12)
b) le substrat transparent (1) et une deuxième vitre (11) sont chauffés à une température de 500°C à 700°C ; et
c) ensuite, le substrat transparent (1) et le deuxième volet (11) sont réunis par un film de laminage (16) de manière à couvrir la surface entièrement.

14. L'utilisation de la vitre transparente selon l'une des revendications 1 à 10 comme vitre ou comme élément d'une vitre, en particulier comme élément d'un vitrage isolant ou d'une vitre feuilletée, dans des bâtiments ou dans des moyens de transport pour la circulation sur terre, dans les airs ou sur l'eau, en particulier dans des véhicules automobiles, par exemple comme pare-brise, lunette arrière, fenêtre latérale et/ou fenêtre de toit.
